Europäisches Patentamt

**European Patent Office**

**Office européen des brevets**

(19)

(11) Publication number: **0 008 928**

**B1**

(12)

# EUROPEAN PATENT SPECIFICATION

(45) Date of publication of patent specification: **20.07.83**

(51) Int. Cl.³: **H 01 L 21/31**

(21) Application number: **79301778.1**

(22) Date of filing: **30.08.79**

(54) A method of making a semiconductor device.

(30) Priority: **31.08.78 JP 106761/78**

(43) Date of publication of application:
**19.03.80 Bulletin 80/6**

(45) Publication of the grant of the patent:
**20.07.83 Bulletin 83/29**

(84) Designated Contracting States:
**DE FR GB**

(56) References cited:
**DE - A - 2 040 180**
**FR - A - 2 313 770**
**GB - A - 1 494 569**
**JP - A - 50 006 143**
**US - A - 3 300 339**

(73) Proprietor: **FUJITSU LIMITED**
**1015, Kamikodanaka Nakahara-ku**
**Kawasaki-shi Kanagawa 211 (JP)**

(72) Inventor: **Shirai, Kazunari**
**32 Tsukimidai Hodogaya-ku**
**Yokohama-shi Kanagawa 240 (JP)**
Inventor: **Tanaka, Izumi**
**2-2-11 Fujitsuka Kohoku-ku**
**Yokohama-shi Kanagawa 222 (JP)**
Inventor: **Tanaka, Shinpei**
**6-11-209 Susukino 3-chome Midori-ku**
**Yokohama-shi Kanagawa 227 (JP)**
Inventor: **Nishimoto, Keiji**
**2737 Eda-cho Midori-ku**
**Yokohama-shi Kanagawa 227 (JP)**

(74) Representative: **Rackham, Stephen Neil et al,**
**GILL JENNINGS & EVERY 53-64 Chancery Lane**
**London WC2A 1HN (GB)**

Courier Press, Leamington Spa, England.

# A method of making a semiconductor device

The present invention relates to a method of making a semiconductor device, and particularly to an improvement in a method of smoothing or rounding the edges of a window through a glass film to prevent fracture of a material forming wiring of the device crossing such edges.

It has been proposed by Intel Corporation, in Japanese Published Patent Application No. 50-6143, that the edges of a glass layer formed on an insulating layer, covering a semiconductor substrate, be smoothed or rounded by the following procedure. After forming windows in the glass layer to expose pertinent portions of the semiconductor substrate, the glass film is heated so that the edges of a window are rounded and smoothed by plastic flow of the glass material, and then wiring is provided in electrical contact with the exposed part of the semiconductor substrate through the smoothed window. It is possible by means of this proposed process to smooth or round the edges formed at the shoulder part of a window through a glass layer, for example, the phosphosilicate glass (PSG) layer of an N channel MIS type semiconductor device, in which N type source and drain regions are formed on a P type semiconductor substrate. In the production of such an N channel MIS type semiconductor device, when a layer of an electrode metal, for example aluminium, is to be located on the source and drain regions, the phosphosilicate glass (PSG) is melted to smooth the edges of the window to prevent the fracture of the wiring at the edges of the window. However, when the melting treatment as proposed in the Japanese Published Patent Application No. 50-6143 is applied to the P channel MIS type semiconductor device, phosphorus from the PSG layer forms a phosphorus diffusion layer on the. surface of the P type source and drain regions during melting of the PSG layer which can result in poor contact or increased contact resistance between the wiring and these regions. Furthermore, in the production of the N channel MIS type semiconductor device, phosphorus diffuses from the PSG layer into the N type source and drain regions to upset the doping of these regions and hence upset the junction depth and electrical resistance of the source and drain regions.

United States of America Patent Specification No. 3 300 339 discusses covering the surface of a semiconductor device with a protective layer such as an impurity containing borosilicate glass and subsequently heating the glass layer to cause it to flow. This specification discusses that the impurities present in the glass diffuse into the substrate and that to avoid this a barrier layer of silicon dioxide is interposed between the glass layer and the substrate.

According to this invention, a method of making a semiconductor device having a semiconductor substrate, an insulating film formed on one region of the substrate and an electrode comprises providing a masking film including a layer of silicon nitride to inhibit impurity penetration over at least the one region of the substrate, forming a glass layer including at least one electrode window on top of the masking film, the glass layer containing impurities, heating the glass layer to round the edges of the at least one electrode window, then subjecting the material exposed through the at least one electrode window to a heat treatment under a hydrogen atmosphere whilst the masking film is heated to a temperature of at least 800°C at which it is permeable to hydrogen to stabilise the interface between the substrate and the insulating layer, and then depositing material to form the electrode and wiring on the at least one electrode window and extending over the rounded edge away from the at least one window.

The important points of the present invention are that the masking film which inhibits impurity penetration, is formed between the insulating layer and the glass layer, and further that the semiconductor substrate is subjected to a heat treatment under a hydrogen atmosphere after the heating of the glass layer and before the deposition of the material to form the wiring layer. The heating under a hydrogen atmosphere improves and stabilises the interface conditions between the semiconductor substrate and the insulating film and this, in combination with the measures for preventing impurity penetration ensure the correct contact conditions between a wiring material and active regions of a semiconductor device such as the source and drain regions of a P-channel MIS type semiconductor device.

In the method of the present invention, the masking film inhibits diffusion of impurities from the glass layer which may be formed by arsenic silicate glass, borosilicate glass and especially phosphosilicate glass (PSG), into the semiconductor substrate. In particular the penetration of phosphorus from a PSG layer into P type regions of the semiconductor substrate is inhibited by the masking film. The masking film may be formed by a single layer of silicon nitride, but preferably it is formed by two layers consisting of a lower silicon dioxide layer closest to the substrate and an upper silicon nitride layer. One of the functions of the lower silicon dioxide layer is to protect the semiconductor substrate from being etched during the etching of the upper silicon nitride layer. When the silicon nitride layer is subjected to plasma etching by means of, for example, tetrafluoroethane gas, if the silicon dioxide layer has a thickness ranging from 200 to 300 Å, it effectively interrupts the effects of the tetrafluoroethane gas. Another function of the lower silicon dioxide layer is to inhibit the penetration of phosphorus precipitated from the PSG layer into the semiconductor substrate. The silicon dioxide layer may be produced by a known thermal oxidation of the silicon substrate and preferably has a thickness in the range from 200 to 300 Å. The silicon nitride layer may be produced by a known chemical vapour deposition method using ammonia and monosilane and preferably has a thickness in the range of from 400 to 500 Å.

The silicon nitride layer, on which the glass layer is deposited, need not be removed before the heat treatment step. It is, therefore, possible to produce an MIS type semiconductor device by a simple process without an inconvenient step of the selective removal of the silicon nitride layer. The silicon nitride layer does not inhibit the penetration of hydrogen gas when the film is heated to a temperature above 800°C and thus the heat treatment under the hydrogen atmosphere according to the present invention can be carried out equally effectively at any point in the production of a semiconductor after the heat treatment of the glass layer and before the deposition of the material to form the wiring. In addition to this heat treatment, a known heat treatment under a hydrogen atmosphere at a low temperature of from 400 to 500°C, may also be carried out. The surface state of the semiconductor substrate, especially at the interface between the semiconductor substrate and the insulating layer, is considerably improved by the heat treatment under hydrogen. The heating time at the high and low temperatures mentioned above ranges from 20 to 60 minutes. Devices made in accordance with the present invention are more stable and thus the changes in their properties with time can be reduced to a level lower than that obtained by any conventional process.

A particular example of a process for producing a P-channel metal insulating semiconductor (MIS) device in accordance with the present invention will now be described with reference to the accompanying drawings; in which:—

Figures 1 to 5 are partial cross-sections through a semiconductor device at various stages in its production; and

Figure 6 is a graph indicating changes of the source current with time.

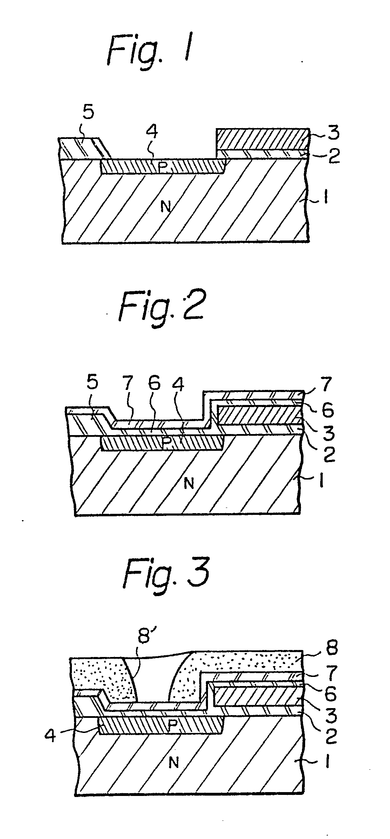

Referring to Figure 1, a process for producing the silicon gate MISFET will now be described. A gate oxide film 2 having a thickness of from 500 to 1000 Å is selectively formed on an N type silicon semiconductor substrate 1. A gate electrode 3, consisting of polycrystalline silicon and having a thickness of from 3000 to 5000 Å, is formed on the gate oxide film 2. Impurities, which provide the N type silicon semiconductor substrate 1 with a P type conductivity, are introduced into the substrate 1 in a concentration of from $10^{19}$ to $10^{21}$/cm³, using the gate electrode 3 as a mask, and source and drain regions, only one of which is shown, are denoted by reference numeral 4 in Figure 1, are thus formed. Reference numeral 5 indicates a field oxide film. As shown in Figure 2, a silicon dioxide ($SiO_2$) film 6 having a thickness of from 200 to 300 Å is formed by a thermal oxidation, and a silicon nitride ($Si_3N_4$) film 7 having a thickness of from 400 to 500 Å is deposited by a conventional vapour phase growth deposition on the entire surface of the semiconductor device being produced. It is also possible to use a sputtering method to provide the film 7 instead of the vapour phase growth deposition. The films 6 and 7 provide a masking film to prevent impurity penetration into the substrate.

A protecting glass film containing an impurity in this case a phosphosilicate glass (PSG) film 8 of a thickness of from 5000 to 15000 Å preferably about 10000 Å is formed. Regions of the PSG film which are to contain electrode windows are then etched by photolithographic techniques using a solution of ammonium fluoride and hydrogen fluoride ($NH_4F+HF$) as the etching agent, to provide precursory electrode windows 8' for electrode contacts.

In addition to the phosphosilicate glass, arsenosilicate glass (AsSG), borosilicate glass (BSG) or phosphosilicate glass containing germanium (GePSG), may be used as the protecting glass 8, however, they are not preferred because the properties such as the melting point and the electrical properties of phosphosilicate glass (PSG) are better than those of these glass materials.

The glass film 8 is then softened by heating it to a temperature of from 1050 to 1100°C, and at this temperature the surface of the glass becomes smooth and, especially, the edge portion of the phosphosilicate glass film 8 defining the precursory electrode window 8' is provided with a gradual slope and becomes rounded and smoothed. During this heat treatment phosphorus tends to diffuse out of the phosphosilicate glass (PSG) film 8. However, the masking films 6 and 7 stop the phosphorus diffusing out of the glass 8 entering the P type region 4.

Subsequently, the semiconductor substrate is heated under a hydrogen atmosphere, at a temperature of from 800 to 900°C, over a period of approximately 20 minutes. Since the heating temperature under the hydrogen atmosphere is adjusted so that it is higher than the conventional temperature of approximately 450°C, for example, to a temperature of from 800 to 900°C, the penetration of hydrogen is not inhibited by the silicon nitride film since the film 7 is permeable to hydrogen at this temperature.

The PSG glass layer 8 is used as a mask in the removal of the silicon nitride film 7 and the silicon dioxide film 6 from the precursory electrode windows 8'. The silicon nitride film 7 is etched using carbon tetrafluoride gas as the etching agent in a plasma etching process. In this case, the etching rate of the silicon nitride film 7 is approximately 100 times higher than that of the phosphosilicate glass (PSG) layer 8. Accordingly, it is possible to remove the silicon nitride film 7 while only a small amount of the phosphosilicate glass (PSG) film 8 is etched. Then, the silicon dioxide film 6 is etched by applying a chemical etching method using a solution of ammonium fluoride and hydrogen fluoride ($NH_4F+HF$). With such an etching step whilst the silicon dioxide film 6 of 200 Å thickness is etched, the windows are widened by approximately 2500 Å. Such enlargement of the width of the windows can be ignored, when compared with the ordinary size of the windows. Thus, a window 8'' for an electrode contact is completed and a portion of the surface of the P. type region 4 is exposed in the completed window 8''. It is also possible to utilise a sputtering method or an ion etching method instead of a chemical etching method to etch the film 6.

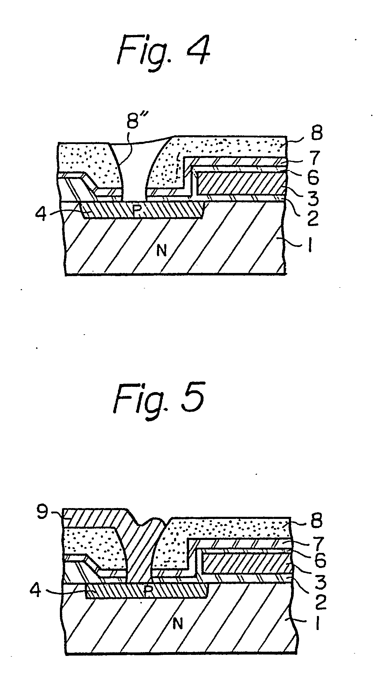

After the window 8'' is completed, aluminium 9 is deposited on the entire surface of the device to provide electrodes for the source and drain and wiring for the device. The aluminium 9 is then selectively etched as shown in Figure 5. The electrode pattern of aluminium is formed by applying one of the ordinary methods, e.g. evaporation method and photolithographic method to the electrode pattern formation. The semiconductor substrate is then heated under a hydrogen atmosphere to a temperature of from 400 to 500°C after the deposition of the layer or the formation of the aluminium electrodes. It will be apparent that the silicon nitride is not removed, except at the windows 8'' and accordingly, the process for producing the type of a semiconductor device is simplified. The reliability of the device made by this process is enhanced and, in addition, inadequate contact between the electrode and the substrate is prevented.

Although the producing process according to the present invention has been described with reference to Figures 1 to 5, in which a metal insulator semiconductor device is illustrated, the process can also be applied to the production of an MOS capacitor, since it prevents an impurity of a first conductivity type being diffused out of an impurity-containing glass film and entering a region of second conductivity type to impede ohmic contact between this region and a metal electrode.

The present invention will now be explained further by way of the following Example.

Example

A random access memory device having a capacity of 4 k bits was produced by the following procedure.

A 700 Å thick gate oxide film 2 of an MIS semiconductor device was selectively formed on an N type silicon semiconductor substrate 1. Polycrystalline silicon was deposited on the gate oxide film 2 to a thickness of 4000 Å to form a gate electrode 3. Impurities were introduced into the substrate 1 in a concentration of $10^{20}/cm^3$, thereby forming source and drain regions. One of these regions is shown in Figure 1 denoted by reference numeral 4. A silicon dioxide film 6 was formed by a thermal oxidation method to a thickness of 300 Å and a silicon nitride film 7 was grown by a vapour phase method to a thickness of 500 Å. After deposition of a 10000 Å thick PSG film 8, and etching thereof to form a precursory window 8', the PSG film 8 was softened at a temperature of 1050°C, so as to round the edges of the precursory window 8'. The semiconductor substrate 1 was then heated to 900°C, in a hydrogen atmosphere, for 20 minutes. The films 6 and 7 were then etched from the base of the window 8' and an aluminium electrode 9 deposited in the window. The random access memory device so produced was tested by measuring the source current between two terminals $V_{DD}$ (5 V) and $V_{SS}$ (0 V) (not shown) for a period of 130 minutes.

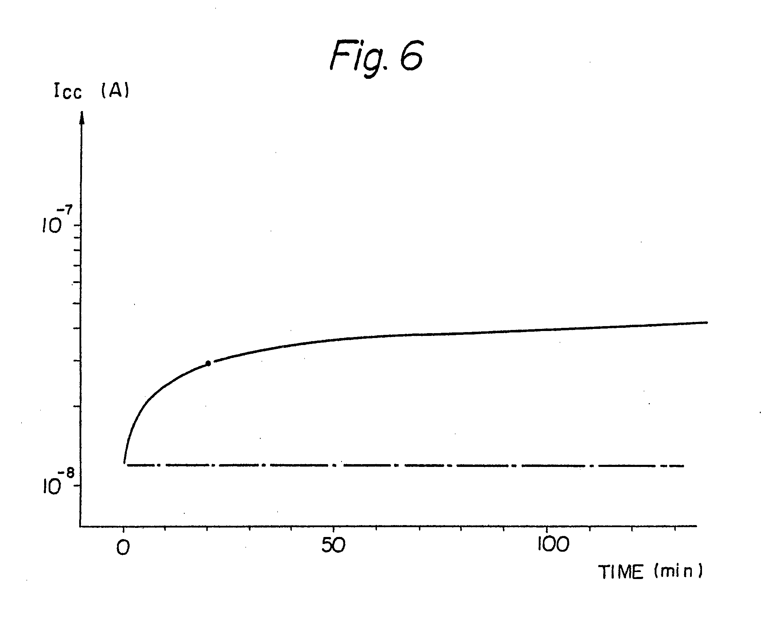

Figure 6 shows plots of these measurements. The source current ($I_{cc}$) indicated by the chain dotted line illustrates the device made in accordance with the present invention and shows almost no secular change in this current. The source current ($I_{cc}$) is the total current through one chip of the random access memory device.

For comparison purposes, the secular change of the source current ($I_{cc}$) was measured with regard to a random access memory device which was produced by the procedure mentioned above, except for the heating at 900°C in the hydrogen atmosphere. The solid line in Figure 6 illustrates the change in the source current ($I_{cc}$) that occurred in this random access memory device.

## Claims

1. A method of making a semiconductor device having a semiconductor substrate, an insulating layer formed on one region of the substrate and an electrode, the method comprising providing a masking film including a layer of silicon nitride to inhibit impurity penetration over at least the one region of the substrate, forming a glass layer including at least one electrode window on top of the masking film, the glass layer containing impurities, heating the glass layer to round the edges of the at least one electrode window, then subjecting the material exposed through the at least one electrode window to a heat treatment under a hydrogen atmosphere whilst the masking film is heated to a temperature of at least 800°C at which it is permeable to hydrogen to stabilise the interface between the substrate and the insulating layer, and then depositing material to form the electrode and wiring on the at least one electrode window and extending over the rounded edge away from the at least one window.

2. A method according to claim 1, in which the semiconductor device is a MISFET and includes a source region and a drain region formed on opposite sides of the one region on the semiconductor substrate, and in which the method includes forming the masking film over the source and drain regions as well as over the one region which forms the channel region of the MISFET.

3. A method according to claim 1 or 2, in which the masking film consists of a silicon dioxide layer closest to the substrate and the silicon nitride layer on the side of the silicon dioxide layer away from the substrate.

4. A method according to any of the preceding claims, in which the heating temperature under a hydrogen atmosphere is in a range from 800°C to 900°C.

5. A method according to any one of the preceding claims, in which the device is also subjected to a heat treatment at a temperature of from 400°C to 500°C under a hydrogen atmosphere after the deposition of the material to form wiring.

6. A method of making a MISFET having a semiconductor substrate, on which a source region and a drain region are formed with a channel region positioned between the source and drain regions, a gate insulating layer formed on the channel region, and a gate electrode formed on the gate insulating layer, comprising forming the gate insulating layer, forming the gate electrode on the gate insulating layer, forming the source and drain regions so that the gate electrode is positioned between these regions; forming a masking film including a layer of silicon nitride to inhibit impurity penetration over the source and drain regions and the gate electrode; forming a glass layer over the masking film, the glass layer containing an impurity; opening precursory electrode windows through predetermined portions of the glass layer against the source and drain regions and the gate electrode subjecting the glass layer to a heat treatment to round its edges; opening an aperture at the precursory windows through the masking film, thereby completing electrode windows to expose portions of the source and drain regions and the gate electrode; depositing a material to form electrodes and wiring on the electrode windows and extending away from the windows; and, subjecting the partly formed device to a heat treatment under a hydrogen atmosphere after the heat treatment of the glass layer and before the deposition of the material to form wiring, the heat treatment being carried out at a temperature of at least 800°C at which the masking film is permeable to hydrogen, the heat treatment stabilising the interface between the substrate and the gate insulating film.

7. A method of making an MOS capacitor having a semiconductor substrate, an insulating layer formed on one region of the semiconductor substrate, and an electrode formed on the insulating layer, comprising forming the insulating layer; forming a masking film including a layer of silicon nitride to inhibit impurity penetration over the substrate; forming a glass layer over the masking film, the glass layer containing an impurity; opening a precursory electrode window through a predetermined portion of the glass layer; subjecting the glass layer to a heat treatment to round the edges of the window; opening an aperture at the precursory window through the masking film, thereby completing the electrode window; depositing a material on the completed window to form an electrode and wiring which extends over the rounded edge and away from the window; and, subjecting the partly formed device to a heat treatment under a hydrogen atmosphere after the heat treatment of the glass layer and before the deposition of the material to form the wiring, the heat treatment under a hydrogen atmosphere being carried out at a temperature of at least 800°C at which the masking film is permeable to hydrogen, the treatment stabilising the interface between the insulating film and the substrate.

**Patentansprüche**

1. Verfahren zur Herstellung einer Halbleiter-Vorrichtung mit einem Halbleitersubstrat, einer isolierenden Schicht auf einem Bereich des Substrats und einer Elektrode, dadurch gekennzeichnet,

daß auf wenigstens einem Bereich des Substrats ein Maskenfilm ausgebildet wird, welcher eine Schicht aus Siliziumnitrid umfaßt, um zu verhindern, daß Verunreinigungen hindurchdringen,

daß eine Glasschicht, welche Verunreinigungen enthält, ausgebildet wird, die wenigstens ein Elektrodenfenster auf der Oberseite des Maskenfilms aufweist,

daß die Glasschicht erhitzt wird, um die Kanten zumindest eines Elektrodenfensters abzurunden,

daß das Material, welches durch das bzw. die Elektrodenfenster exponiert ist, einer Wärmebehandlung unter Wasserstoffatmosphäre ausgesetzt wird, während der Maskenfilm auf eine Temperatur von wenigstens 800°C aufgeheizt wird, bei welcher er für Wasserstoff permeabel ist, um die Grenzschicht zwischen dem Substrat und der isolierenden Schicht zu stabilisieren,

und daß dann Material deponiert wird, um die Elektrode und die Verdrahtung des wenigstens einen Elektrodenfensters zu bilden und sich über die abgerundete Kante dieses Fensters hinweg zu erstrecken.

2. Verfahren nach Anspruch 1, dadurch gekennzeichnet, daß die Halbleiter-Vorrichtung ein MISFET is und wenigstens einen Quellbereich und einen Senkenbereich umfaßt, die an entgegengesetzten Seiten des einen Bereichs des Halbleitersubstrats ausgebildet sind und daß ein Maskenfilm sowohl über den Quellbereichen und den Senkenbereichen als auch über dem einen Bereich ausgebildet wird, welcher den Kanalbereich des MISFET bildet.

3. Verfahren nach Anspruch 1 oder 2, dadurch gekennzeichnet, daß der Maskenfilm auf der dem Substrat am nächsten liegenden Seite aus einer Siliziumdioxidschicht, und auf der Seite der Siliziumdioxidschicht, welche von dem Substrat entfernt ist, aus einer Siliziumnitridschicht besteht.

4. Verfahren nach einem der vorhergehenden Ansprüche, dadurch gekennzeichnet, daß die Heiztemperatur unter Wasserstoffatmosphäre im Bereich zwischen 800°C und 900°C liegt.

5. Verfahren nach einem der vorhergehenden Ansprüche, dadurch gekennzeichnet, daß die Vorrichtung nach Deposition des Materials, welches die Verdrahtung bildet, außerdem einer Wärmebehandlung in einem Temperaturbereich zwischen 400°C und 500°C unter einer Wasserstoffatmosphäre ausgesetzt wird.

6. Verfahren zur Herstellung eines MISFET mit einem Halbleitersubstrat, auf welchem ein Quellbereich und ein Senkenbereich und zwischen diesen ein Kanalbereich ausgebildet sind, und bei welchem eine Gate-Isolierschicht auf dem Kanalbereich und eine Gate-Elektrode auf der Gate-Isolierschicht ausgebildet sind, dadurch gekennzeichnet,

daß die Gate-Isolierschicht gebildet wird, daß die Gate-Elektrode auf der Gate-Isolierschicht gebildet wird,

daß die Quell- und Senkenbereiche gebildet werden, so daß die Gate-Elektrode zwischen diesen Bereichen positioniert wird,

daß ein Maskenfilm, welcher eine Schicht aus Siliziumnitrid zur Verhinderung von Verunreinigungspenetrationen umfaßt, über den Quell- und den Senkenbereichen und der Gate-Elektrode gebildet wird,

daß eine Glasschicht, welche Verunreinigungen enthält, über dem Maskenfilm gebildet wird,

daß ein vorläufiges Elektrodenfenster durch vorbestimmte Abschnitte der Glasschicht gegenüber den Quellbereichen und den Senkenbereichen und der Gate-Elektrode gebildet wird,

daß die Glasschicht einer Wärmebehandlung zur Abrundung ihrer Kanten ausgesetzt wird,

daß eine Öffnung bei den vorläufigen Fenstern durch den Maskenfilm geschaffen wird, wodurch die Elektrodenfenster vervollständigt werden, um Abschnitte der Quell- und Senkenbereiche und der Gate-Elektrode zu exponieren,

daß ein Material deponiert wird, um Elektroden und Verdrahtung auf den Elektrodenfenstern zu bilden, welche sich von diesen Fenstern fort erstrecken,

und daß die teilweise ausgebildete Vorrichtung, nach der Wärmebehandlung der Glasschicht und vor der Deponierung des Materials zur Bildung der Verdrahtung, unter Wasserstoffatmosphäre einer Wärmebehandlung von wenigstens 800°C ausgesetzt wird, bei welcher der Maskenfilm für Wasserstoff permeabel wird, wobei die Wärmebehandlung die Grenzschicht zwischen dem Substrat und dem Gate-Isolierfilm stabilisiert.

7. Verfahren zur Herstellung eines MOS-Kondensators mit einem Halbleitersubstrat, einer Isolierschicht auf einem Bereich des Halbleitersubstrats und einer auf der Isolierschicht ausgebildeten Elektrode, dadurch gekennzeichnet,

daß eine Isolierschicht ausgebildet wird,

daß über dem Substrat ein Maskenfilm ausgebildet wird, welcher eine Schicht aus Siliziumnitrid umfaßt, um ein Durchdringen von Verunreinigungen zu verhindern,

daß über dem Maskenfilm eine Glasschicht ausgebildet wird, welche eine Verunreinigung enthält,

daß durch eine vorbestimmten Abschnitt der Glasschicht ein vorläufiges Elektrodenfenster geöffnet wird,

daß die Glasschicht einer Wärmebehandlung unterworfen wird, um die Kanten des Fensters abzurunden,

daß durch den Maskenfilm eine Öffnung bei dem vorläufigen Fenster hergestellt wird, wodurch das Elektrodenfenster vervollständigt wird,

daß auf dem fertigen Fenster Material deponiert wird, um eine Elektrode und Verdrahtung zu bilden, welche sich von dem Fenster fort über dessen abgerundete Kante erstreckt,

und daß die teilweise ausgebildete Vorrichtung, nach der Wärmebehandlung der Glasschicht und vor der Deposition des Materials zu Bildung der Verdrahtung, unter Wasserstoffatmosphäre einer Wärmebehandlung bei einer Temperatur von wenigstens 800°C unterworfen wird, bei welcher der Maskenfilm für Wasserstoff permeabel ist, wobei die Wärmebehandlung zur Stabilisierung der Grenzschicht zwischen dem isolierenden Film und dem Substrat dient.

**Revendications**

1. Procédé de fabrication d'un dispositif semi-conducteur comportant un substrat semi-conducteur, une couche isolante formée sur une première région du substrat, et une électrode, le procédé consistant à produire une pellicule de masquage comportant une couche de nitrure de silicium afin d'empêcher la pénétration d'impuretés sur au moins la première région du substrat, former une couche de verre comportant au moins une fenêtre pour électrode sur le dessus de la pellicule de masquage, la couche de verre contenant des impuretés, chauffer la couche de verre pour adoucir les bords de la ou des fenêtres pour électrode, puis soumettre le matériau exposé par la ou les fenêtres pour électrode à un traitement thermique sous atmosphère d'hydrogène tout en chauffant la pellicule de masquage jusqu'à une température d'au moins 800°C, à laquelle elle est perméable à l'hydrogène, pour stabiliser l'interface entre le substrat et la chouche isolante, et, ensuite, déposer un matériau pour former l'électrode et le câblage sur la ou les fenêtres pour électrode et le faire sortir hors de la ou des fenêtres en le faisant passer sur le bord adouci.

2. Procédé selon la revendication 1, dans lequel le dispositif semi-conducteur est un TECMIS et comporte une région de source et une région de drain formées de part et d'autre de la première région sur le substrat semiconducteur, et dans lequel le procédé comporte l'opération consistant à former la pellicule de masquage au-dessus des régions de source et de drain aussi bien qu'au-dessus de la première région qui constitue la région de canal de TECMIS.

3. Procédé selon la revendication 1 ou 2, dans lequel la pellicule de masquage consiste en une couche de dioxyde de silicium, située au plus près du substrat, et en la couche de nitrure de silicium, qui est placée sur le côté de la couche de dioxyde de silicium qui est opposé au substrat.

4. Procédé selon l'une quelconque des revendications précédentes, dans lequel la température de chauffage sous atmosphère d'hydrogène est comprise entre 800°C et 900°C.

5. Procédé selon l'une quelconque des revendications précédentes, dans lequel le dispositif est également soumis à un traitement thermique à une température de 400°C sous atmosphère d'hydrogène après le dépôt du matériau destiné à former le câblage.

6. Procédé de fabrication d'un TECMIS comportant un substrat semi-conducteur, sur lequel une région de source et une région de drain sont formées de façon qu'une région de canal soit placée entre les régions de source et de drain, une couche isolante de grille formée sur la région de canal, et une électrode de grille formée sur la couche isolante de grille, consistant à former la couche isolante de grille, former l'électrode de grille sur la couche isolante de grille, former les régions de source et de drain de façon que l'électrode de grille soit placée entre ces régions, former une pellicule de masquage comportant une couche de nitrure de silicium afin d'empêcher la pénétration d'impuretés sur les régions de source et de drain et sur l'électrode de grille; former une couche de verre sur la pellicule de masquage, la couche de verre contenant une impureté; ouvrir des ébauches de fenêtres pour électrode au travers de parties prédéterminées de la couche de verre en regard des régions de source et de drain et de l'électrode de grille en soumettant la couche de verre à une traitement thermique afin d'adoucir ses bords; ménager une ouverture au niveau des ébauches de fenêtres au travers de la pellicule de masquage, pour ainsi achever les fenêtres pour électrode afin d'exposer des parties des régions de source et de drain et l'électrode de grille; déposer un matériau pour former des électrodes et un câblage sur les fenêtres pour électrode et le prolonger hors des fenêtres; et soumettre le dispositif partiellement formé à un traitement thermique sous atmosphère d'hydrogène après le traitement thermique de la couche de verre et avant le dépôt du matériau destiné à former le câblage, le traitement thermique étant effectué à une température d'au moins 800°C, à laquelle le pellicule de masquage est perméable à l'hydrogène, et le traitement thermique stabilisant l'interface entre le substrat et la pellicule isolante de grille.

7. Procédé de fabrication d'un condensateur MOS possédant un substrat semi-conducteur, une couche isolante formée sur une première région du substrat semi-conducteur, et une électrode formée sur la couche isolante, consistant à former la couche isolante; former une pellicule de masquage comportant une couche de nitrure de silicium pour empêcher la pénétration d'impuretés sur le substrat; former une couche de verre sur la pellicule de masquage, la couche de verre contenant une impureté; ouvrir une ébauche de fenêtre pour électrode au travers d'une partie prédéterminée de la couche de verre; soumettre la couche de verre à une traitement thermique afin d'adoucir les bords de la fenêtre; ménager une ouverture au niveau de l'ébauche de fenêtre au travers de la pellicule de masquage, pour achever la fenêtre pour électrode; déposer un matériau sur la fenêtre achevée pour former une électrode et un câblage qui s'étend sur le bord adouci et hors de la fenêtre; et soumettre le dispositif partiellement formé à un traitement thermique sous atmosphère d'hydrogène après le traitement thermique de la couche de verre et avant le dépôt du matériau destiné à former le câblage, le traitement thermique sous atmosphère d'hydrogène étant effectué à une température d'au moins 800°C, à laquelle la pellicule de masquage est perméable à l'hydrogène, et le traitement stabilisant l'interface entre la pellicule isolante et le substrat.

*Fig. 1*

*Fig. 2*

*Fig. 3*

*Fig. 4*

*Fig. 5*

Fig. 6